# FASCICULE DE BREVET EUROPEEN

(11) **EP 2 926 202 B1**
(45) Date de publication et mention de la délivrance du brevet: **30.07.2025**
(21) Numéro de dépôt: 13795770.0
(22) Date de dépôt: 26.11.2013
(51) Int. Cl.: G04G 17/06, G04G 21/08, G06F 1/16, G06F 3/0482, H03K 17/96

(54) **OBJET ELECTRONIQUE PORTABLE TACTILE**
TRAGBARES ELEKTRONISCHES BERÜHRUNGSEMPFINDLICHES OBJEKT
TOUCH-SENSITIVE PORTABLE ELECTRONIC OBJECT

(30) Priorité: 28.11.2012 EP 12194651; 27.03.2013 EP 13161359
(43) Date de publication de la demande: 07.10.2015
(73) Titulaire: Montres Rado S.A., 2543 Lengnau (CH)
(72) Inventeur: MATTHEY, Gérald, CH-1338 Ballaigues (CH); KLOPFENSTEIN, François, CH-2800 Delémont (CH); ROTA, Sergio, CH-2013 Colombier (CH)
(74) Mandataire: Collé, Emmanuel
(86) Numéro de dépôt international: PCT/EP2013/074752
(87) Numéro de publication internationale: WO 2014/083001

(56) Documents cités:
- EP-A1- 1 610 209
- JP-A- 2001 100 907
- JP-A- 2007 142 577
- JP-A- 2010 035 020
- US-A- 4 468 131
- US-A1- 2009 323 262

## Description

L'invention concerne un objet portable électronique comprenant une boite, ladite boîte comprenant une première partie en matériaux céramiques, ledit objet électronique portable comprenant au moins un module électronique fournissant au moins une information à des moyens d'affichage disposés sous la glace, ledit objet électronique portable comprenant en outre des moyens de commande permettant à l'utilisateur d'agir sur ledit au moins un module horloger électronique.

### ARRIERE PLAN TECHNOLOGIQUE

Un objet portable électronique comme un appareil électronique ou par exemple une pièce d'horlogerie portable comprend une boîte généralement composée d'une carrure fermée par un fond et par une glace. Dans cette boîte, un mouvement horloger est agencé, ce dernier pouvant être purement mécanique ou électronique. Ce mouvement horloger est agencé pour fournir une information horaire, ladite information horaire étant affichée via des moyens d'affichage analogiques ou numériques. La pièce d'horlogerie comprend en outre des moyens de commande permettant à l'utilisateur d'interagir avec ladite pièce d'horlogerie.

En général, les moyens de commande se présentent sous la forme de boutons poussoirs ou d'une couronne agissant mécaniquement sur ledit mouvement horloger. Or, ces poussoirs et couronnes peuvent être complétés avec une interface tactile. Cette interface tactile est utilisée pour améliorer l'interactivité de la pièce d'horlogerie, pour simplifier les manipulations surtout lorsque la pièce d'horlogerie propose un nombre conséquent de menus et de fonctions. Cette interface tactile peut également contribuer à améliorer l'esthétique du produit en permettant d'éliminer les excroissances habituelles d'une couronne ou de poussoirs.

Cette interface tactile peut être une interface tactile résistive ou une interface tactile capacitive. Pour le cas d'une interface tactile capacitive, celle-ci peut se présenter sous la forme d'une électrode placée sur la face inférieure de la glace, cette glace représentant un élément électriquement non conducteur. Cette électrode est soumise à un champ électrique. Lorsque l'utilisateur veut activer l'interface, il exerce un contact sur la face extérieure de la glace, de préférence avec son doigt. On entend par là que ce contact peut être un appui ou un effleurement. Ce contact entraîne l'apparition d'une capacité additionnelle qui se forme entre ladite électrode et le doigt qui est un élément électriquement conducteur. Cette variation de capacité est détectée par le mouvement horloger électronique qui va agir selon sa programmation. Cette interface tactile est réalisée sur la glace de la montre et non pas sur le boîtier car celui-ci est généralement réalisé en métal et est donc électriquement conducteur. Il ne permet pas l'apparition d'une capacité.

Néanmoins, ces interfaces tactiles agencées sur la glace de la pièce d'horlogerie présentent des inconvénients.

Un premier inconvénient de l'agencement de l'interface tactile sur la glace est qu'il ne permet pas une visibilité optimale des informations. En effet, le fait d'avoir une interface tactile agencée sur la glace de la pièce d'horlogerie implique que l'utilisateur doit régulièrement mettre ses doigts sur la glace. Cela a pour conséquences que la visibilité des informations affichées sur le cadran est régulièrement réduite par les doigts de l'utilisateur. Ce dernier a donc plus de difficultés à prendre connaissances des informations fournies par la pièce d'horlogerie.

Un autre inconvénient est qu'avoir une interface tactile associée à des éléments de commandes conventionnels comme des boutons poussoirs ou des couronnes rend la pièce d'horlogerie plus complexe. Effectivement, le fait d'avoir une multitude de boutons en plus de l'interface tactile entraîne que le nombre de combinaisons entre les boutons et l'interface tactile est plus important. La manipulation de la pièce d'horlogerie est donc plus complexe.

Un autre inconvénient est que pour des pièces avec cadran sombre ou affichage en contraste négatif dont le fond est sombre, le fait de régulièrement poser les doigts sur la glace laisse des traces (graisse, sueur,...) qui péjorent l'esthétique du produit (comme une vitre couverte de traces de doigts).

Des exemples d'objets électroniques portables de l'état de l'art sont décrits dans les documents EP 1 610 209, JP 2010 035020, JP 2001 100907, JP 2007 142577 et US 2009/ 323262.

### RESUME DE L'INVENTION

L'invention a pour but de pallier les inconvénients de l'art antérieur en proposant de fournir un objet électronique portable intuitif et simple à utiliser et dont la lecture des informations est claire en toutes circonstances.

A cet effet, l'invention concerne un objet électronique portable, tel que défini dans la revendication 1.

Un avantage de la présente invention est de permettre d'avoir un objet portable électronique qui allie facilité d'utilisation avec une interface tactile intuitive et une bonne visibilité en agençant cette interface tactile sur la boîte de l'objet portable. Ainsi, l'utilisateur évite d'obstruer les moyens d'affichage lorsqu'il utilise l'interface tactile.

Dans un premier mode de réalisation avantageux, ladite au moins une électrode est une feuille réalisée en matériaux électriquement conducteurs fixée sur ledit support.

Dans un second mode de réalisation avantageux, ladite au moins une électrode est directement réalisée sur ledit support.

Dans un troisième mode de réalisation avantageux, les moyens de fixation comprennent au moins une bride de fixation en matériaux conducteurs fixés d'une part au mouvement horloger et d'autre part au support permettant une conduction électrique entre ladite au moins une bride de fixation et ladite au moins une électrode.

Dans un quatrième mode de réalisation avantageux, ledit au moins un système d'électrode comprend une pluralité d'électrode agencée sur un même support.

Dans un autre mode de réalisation avantageux, la carrure est réalisée entièrement en matériaux isolants.

Dans un autre mode de réalisation avantageux, le matériau isolant est une céramique.

Dans un autre mode de réalisation avantageux, les moyens tactiles comprennent au moins un système d'électrode à proximité de la face intérieure de ladite première partie.

Dans un autre mode de réalisation avantageux, les moyens tactiles comprennent au moins un système d'électrode en contact avec la face intérieure de ladite première partie.

Dans un autre mode de réalisation avantageux, le boîtier est formé d'une carrure fermée par une glace et un fond.

Dans un autre mode de réalisation avantageux, l'objet portable est une pièce d'horlogerie.

### BREVE DESCRIPTION DES FIGURES

Les buts, avantages et caractéristiques de l'objet ou appareil électronique portable selon la présente invention apparaîtront plus clairement dans la description détaillée suivante d'au moins une forme de réalisation de l'invention donnée uniquement à titre d'exemple non limitatif et illustrée par les dessins annexés sur lesquels :
- La figure 1 représente schématiquement un appareil électronique portable,
- La figure 2 représente schématiquement une vue en coupe de l'appareil électronique, qui ne fait pas partie de l'invention ;
- La figure 3 représente schématiquement une vue de dessus de l'appareil électronique selon l'invention;
- La figure 4 représente schématiquement une vue en coupe du mouvement de l'appareil électronique selon l'invention ;
- La figure 5 représente schématiquement une première solution du système d'électrode selon l'invention ;
- Le figure 6 représente schématiquement une vue éclatée du module électronique de la pièce d'horlogerie selon l'invention ;
- Les figures 7 à 9 représentent schématiquement trois solutions du système d'électrode, qui ne font pas partie de l'invention ;
- La figure 10 représente schématiquement une variante de la vue en coupe du système d'électrode, qui ne fait pas partie de l'invention.

### DESCRIPTION DETAILLEE

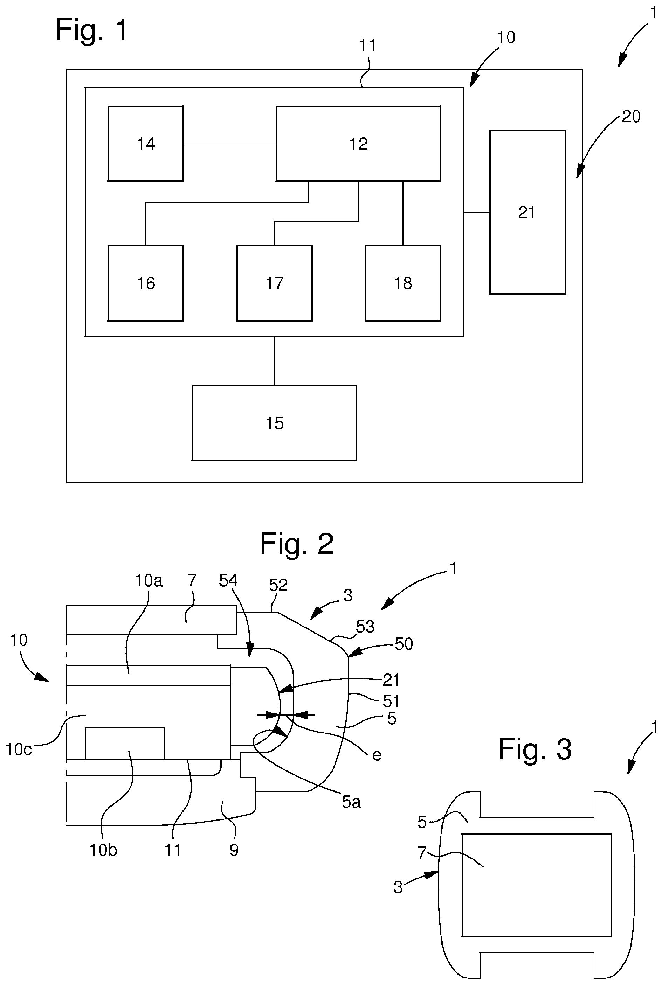

Sur la figure 1, un appareil électronique portable ou objet électronique portable selon l'invention est représenté. Cet objet portable électronique peut être un téléphone portable ou un appareil GPS mobile ou un ordinateur portable ou une tablette tactile, un appareil cardiofréquence-mètre pour le sport ou un baladeur de musique ou une pièce d'horlogerie 1. Nous prendrons dans le reste de la description l'exemple d'une pièce d'horlogerie sans que cet exemple ne soit limitatif. Cette pièce d'horlogerie 1 comprenant un boîtier ou boîte 3 constitué d'une carrure 5 fermée par un fond 9 et par une glace 7. Dans ce boîtier 3, un module électronique 10 est agencé. Ce module électronique 10 est configuré pour fournir au moins une information devant être affichée. Ce module électronique 10 est par exemple un mouvement horloger 11 électronique comprend au moins un microcontrôleur 12 relié à une base de temps 14 et est configuré pour fournir au moins une information de temps comme par l'exemple l'heure courante. Le microcontrôleur 12 peut aussi être un circuit intégré spécifique (ASIC) aux fonctions équivalentes. Ces informations sont envoyées à des moyens d'affichages 15 pouvant être analogiques ou digitales. Ce mouvement horloger 11 peut comprendre en outre différents capteurs comme par exemple un capteur de pression 16 pour fournir une information sur l'altitude ou la profondeur ou sur la météo. Un capteur de température 17 ou un capteur boussole 18 peuvent être également agencés. De plus, il est envisageable que plusieurs modules électroniques 10 soient agencés dans la boîte 3 de la pièce d'horlogerie 1, chacun d'eux fournissant au moins une information. Dans la suite de la présente description, nous considèrerons qu'un seul mouvement horloger électronique est agencé dans ledit boîtier.

Ce mouvement horloger 11 électronique, visible à la figure 2, comprend une platine 10c dans laquelle un logement 10d pour un accumulateur électrique 10b, comme une pile, est creusé. Ce mouvement horloger 10 comprend en outre un circuit imprimé 10a ou PCB sur lequel les différents circuit intégré et composants électrique et électronique sont fixés. Le circuit imprimé 10a et la platine 10c sont agencés pour que les différents composants fixés sur ledit circuit imprimé puissent être alimentés par la pile 10b.

La pièce d'horlogerie 1 comprend en outre des moyens de commande 20 utilisés pour que l'utilisateur puisse interagir avec ledit mouvement horloger 11 électronique. Cela permet à l'utilisateur de pouvoir sélectionner les différentes fonctions et de les activer.

Avantageusement, les moyens de commande 20 comprennent au moins des moyens tactiles 21 agencés sur le boîtier 3 de la pièce d'horlogerie 1. On pourra prévoir que la pièce d'horlogerie ne comprend que des moyens tactiles 21 mais qu'elle peut aussi comprendre en outre au moins un bouton ou une couronne pour agir sur certaines fonctions.

Les moyens tactiles 21 sont du type capacitif. Un tel système capacitif utilise le principe d'une électrode, soumise à un champ électrique, placée sur la face inférieure d'un élément isolant. Une capacité additionnelle se forme lorsque l'utilisateur entre en contact avec l'autre face de l'élément isolant avec son doigt faisant varier la capacité totale vue par le système, ce qui permet une détection.

Les moyens tactiles 21 comprennent un système d'électrode 100 et un élément isolant. Avantageusement, la présente invention prévoit que le boîtier 3 fait office d'élément isolant. Pour cela, le boîtier 3 de la pièce d'horlogerie comprend au moins une première partie 3a réalisée dans un matériau isolant, de préférence un matériau céramique. Un matériau plastique, ou saphir, peut être également utilisé. Cette première partie réalisée 3a en matériau isolant forme ainsi ledit élément isolant nécessaire aux moyens tactiles 21. Cette première partie 3a réalisée en matériau isolant présente ainsi une face extérieure qui est la surface sur laquelle l'utilisateur va agir et une face intérieure sur laquelle un système d'électrode 100 est agencé. Par exemple, la carrure 5 est agencée pour comprendre la première partie 3a réalisée en matériau céramique.

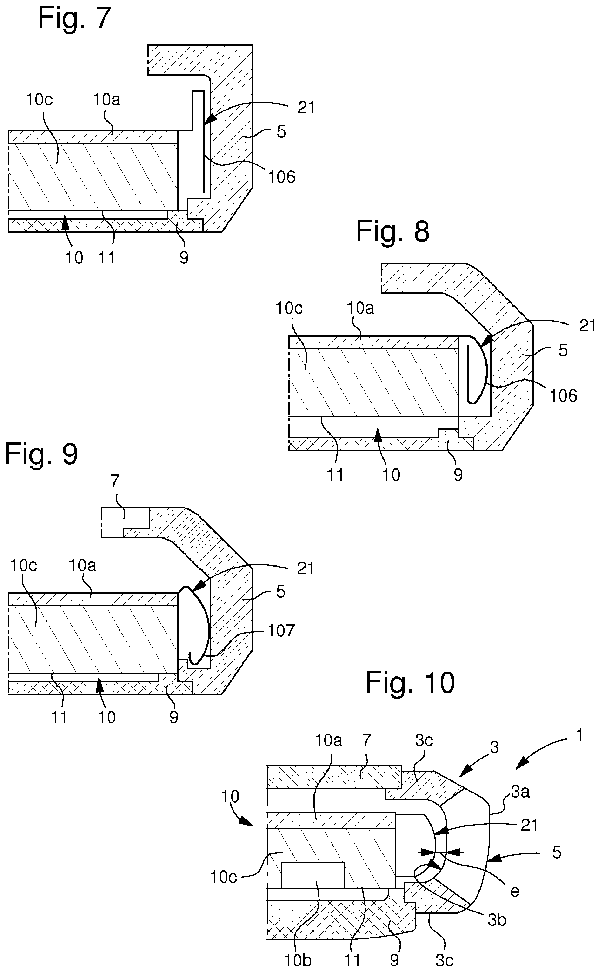

Dans un exemple de réalisation de la carrure 5 visible à la figure 10, celle-ci peut se présenter sous la forme d'un châssis métallique ou plastique 3c ayant une forme identique à la carrure définitive présentant néanmoins un orifice dans lequel la première partie 3a en céramique est insérée. Cette première partie 3a en céramique est solidairement fixée au châssis par collage ou vissage ou tout autre moyen de fixation possible. De façon préférentielle, toute la carrure 5 est réalisée en céramique permettant d'avoir une carrure ou pièce monobloc. On obtient en conséquence un procédé plus simple à réaliser.

Le système d'électrode 100 comprend au moins une électrode 101 électriquement reliée au mouvement horloger 11 électronique. Ce système d'électrode 100 est agencé pour être placé à proximité de la face intérieure 3b de la première partie réalisée 3a en matériaux électriquement non conducteur. Cette proximité avec la face intérieure 3b de la première partie 3a réalisée en matériau isolant permet, lorsque le doigt de l'utilisateur entre en contact avec la face extérieure de ladite première partie, de créer une capacité additionnelle. Cette variation de capacité est détectée par le mouvement horloger 11 électronique qui va agir selon la programmation implémentée dans ledit mouvement horloger électronique.

Par exemple, les moyens tactiles 21 sont agencés sur la carrure au niveau des zones 9h et/ou 3h. On comprend alors que pour un boîtier et carrure de forme carrée, les moyens tactiles 21 sont agencés sur l'une ou les zones de la carrure parallèle à l'axe 12h-6h. Pour un boîtier et carrure de forme circulaires, les moyens tactiles 21 sont agencés sur l'une ou les zones 2h-4h et 8h-10h c'est-à-dire les zones situées entre deux cornes symétriquement opposées. Le fait d'avoir les moyens tactiles 21 agencés sur la carrure au niveau des zones 9h et 3h permet une flexibilité d'utilisation de sorte qu'il est possible de n'activer que les moyens tactiles 21 de la zone 9h si l'utilisateur porte la pièce d'horlogerie au poignet droit ou de n'activer que les moyens tactiles 21 de la zone 3h si l'utilisateur porte la pièce d'horlogerie au poignet gauche. Cette activation sélective des moyens tactiles 21 agencés sur la carrure au niveau des zones 9h et 3h peut être automatique ou manuelle.

Bien entendu, les moyens tactiles peuvent être disposés n'importe où sur la carrure 5.

Dans une réalisation, la carrure 5, entièrement réalisée en matériaux céramiques et visible sur la vue en coupe de la figure 2, présente une géométrie spécifique. Cette géométrie spécifique est configurée de sorte que la carrure est munie de flancs 50 présentant une première portion 51 s'étendant perpendiculairement au fond 9 dudit boîtier 3, une seconde portion 52 s'étendant parallèlement à la glace 7 et situé dans le même plan que la dite glace 7, et une troisième portion 53 inclinée reliant la première portion 51 et la seconde portion 52. Cette configuration permet d'avoir, vue de dessus, des surfaces servant pour les touches tactiles d'une taille permettant aux doigts de l'utilisateur de ne pas glisser. La paroi intérieure 5a de la carrure 5, similaire à la face intérieure 3b de la première partie réalisée 3a, présente une creusure 54 de sorte que le système d'électrode 100 puisse s'y loger. On comprendra que la carrure 5 peut simplement comprendre deux portions perpendiculaires l'une à l'autre.

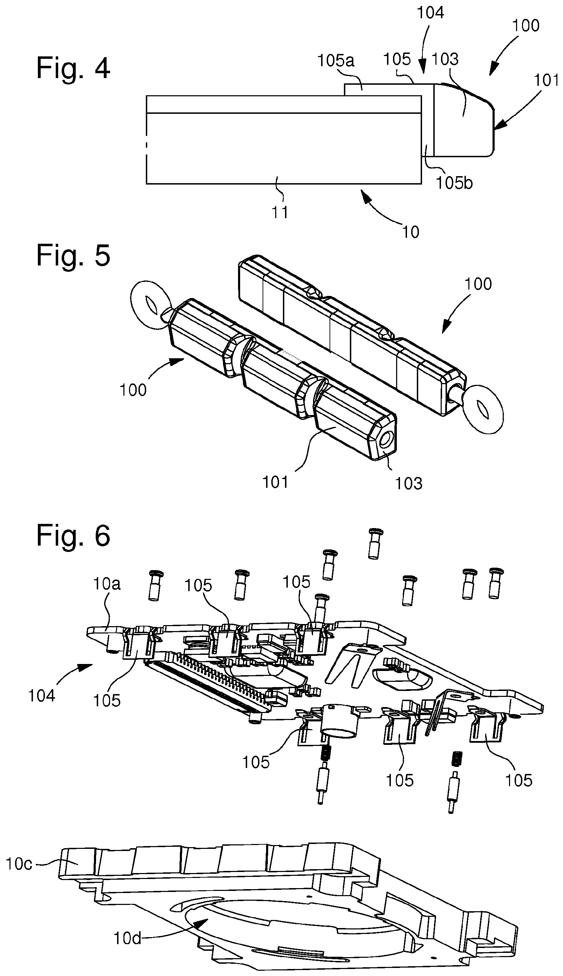

Le système d'électrode 100 de cette réalisation préférée comprend au moins une électrode 101 agencée sur un support 103. La figure 4 ne représente que le module électronique 10 avec le système d'électrode sans la carrure 5. Le support 103 se présente sous la forme d'une pièce en matériaux isolants comme par exemple du plastique, du bois ou de la céramique. Sur ce support 103, au moins une électrode 101 est agencée. Cette électrode 101 est réalisée en un matériau élément électriquement conducteur comme un métal tel que le cuivre ou l'or. Cette électrode 101 peut être constituée d'une feuille métallique fixée au support 103 par brasage, par fixation mécanique ou par collage avec une colle conductrice ou non. Une colle conductrice est chargée en particules comme des particules d'argent assurant la conductivité électrique Il est également possible que l'électrode 101 soit directement réalisée sur le support 103. Par exemple, l'utilisation de technique de croissance galvanique, d'électroformage ou d'électrodéposition permet de déposer une fine couche de matériau électriquement conducteur.

Dans le cas présent, le support 103 présente un profil sensiblement similaire à celui de la creusure 54 agencée sur la paroi intérieure 5a de la carrure 5. Ici, le support 103 présente un profil constitué de deux droites perpendiculaires dont le somment est tronqué de sorte à former un plan incliné c'est-à-dire un profil similaire aux flans 50 celui de la carrure 5. Bien entendu, la creusure 54 de la carrure 5 et le profil du support 103 peuvent avoir les formes les plus diverses. Bien entendu le support 103 et/ou l'électrode 101 peuvent avoir une forme similaire à celle de la carrure 5.

Le mouvement horloger 11 électronique comprend également des moyens de fixation 104 sur lesquels le support 103 se fixe comme visible à la figure 6. Les moyens de fixation 104 sont des brides de fixation 105 selon l'invention telle que revendiquée, qui se présentent sous la forme d'éléments métalliques fixés à la platine 10c ou audit circuit imprimé. Lesdites brides de fixation 105 sont agencées pour être électriquement connectées au circuit imprimé 10a. Par exemple, ces brides de fixation 105 se présentent sous la forme de plaques courbées selon un angle droit de sorte à présenter deux branches. Une première branche 105a est fixée sur le circuit imprimé 10a et connectée électriquement aux différents circuits, de préférence pour être coincée par la platine 10c et ledit circuit imprimé 10a. La seconde branche 105b se retrouve, une fois la platine et le circuit imprimé assemblés, plaquée contre une paroi latéral de ladite platine 10b. Cela permet ainsi de fixer le support 103, portant au moins une électrode 101, sur ladite bride 105. Il peut être alors envisagée que le ou les circuits intégrés qui doivent être électriquement connectés à l'électrode 101, le soient par l'intermédiaire d'un fil ou d'une brasure ou d'une colle conductrice. Avantageusement, la bride de fixation 105 est agencée pour relier électriquement l'électrode et le circuit imprimé.

Dans une variante de cette solution comme visible à la figure 6, il peut être prévu que le support 103 soit conçu pour porter plusieurs électrodes 101. Le support 103 s'étend en conséquence sur une longueur plus importante de sorte que les électrodes 101 puissent se placer les unes à côté des autres. Pour fixer un tel support, plusieurs brides de fixation 105 sont utilisées pour assurer une bonne fixation. De préférence, on utilisera un nombre de brides de fixation 105 égal au nombre d'électrodes 101 de sorte que chaque électrode 101 soit reliée électriquement au circuit imprimé 10c par une bride de fixation 105.

Lorsque le mouvement horloger 11 électronique avec le support 103 munis des électrodes 101 et les moyens de fixation 104 sont insérés dans le boîtier 3, il est envisageable que les électrodes 101 puissent être en contact de la paroi intérieure 5a de la carrure 5 ou au contraire, qu'un espace (e) soit présent entre les électrodes 101 et ladite paroi intérieure 5a comme visible à la figure 2. Comme l'air ambiant est naturellement un diélectrique, la présence de cet espace (e) n'est pas forcément gênante. Cet espace (e) engendre simplement une modification de la capacité électrique intrinsèque du dispositif. Il est donc envisageable que la capacité intrinsèque et, par conséquent, la sensibilité des moyens tactiles 21 puissent être ajustées par rapprochement ou éloignement de l'électrode 101 par rapport à la face intérieure 3b de la carrure 5.

Il peut être avantageusement prévu que la présence de cet espace (e) soit désirée. Effectivement, un tel espace (e) peut être utilisé pour faciliter le montage du module horloger électronique 11. Ce dernier est assemblé avant d'être monté ce qui signifie que le système d'électrode 100 est fixé au mouvement horloger 11 avant que celui-ci ne soit inséré dans le boîtier 3. Le surplus d'espace peut permettre d'ajuster la position du mouvement horloger 11.

L'espace entre le système d'électrode 100 et la carrure 5 peut être rempli, une fois que le mouvement horloger 10 est fixé dans le boîtier. Cet espace (e) peut être rempli avec un matériau isolant comme de la résine plastique ou alors sélectivement pour chaque électrode avec un matériau conducteur tel que de la colle conductrice en évitant de relier les différentes électrodes entre elles sous peine de court-circuit. Cette colle conductrice peut améliorer la conductivité électrique.

Bien entendu, il est envisageable que le système d'électrode 100 puisse se présenter sous une forme différente.

Dans une autre solution, il est envisageable que les brides de fixation 105 elles-mêmes fassent office d'électrodes. En effet, les brides de fixation 105 sont réalisées en matériaux électriquement conducteur pour permettre la connexion électrique entre l'électrode 101 et le circuit imprimé 10a. Pour qu'un tel effet se produise, il est nécessaire que les brides de fixation 105 soient proches de la face intérieure 3b de la première partie 3a. Cette solution permet d'avoir les électrodes formées par des structures métalliques directement fixées et directement connectées au circuit imprimé 10a.

Dans une variante visible aux figures 7 et 8, qui ne font pas partie de l'invention, les structures métalliques ne sont pas des brides de fixation 105 mais des structures métalliques 106 exclusivement réalisées pour être des électrodes. La forme de ces structures métalliques est conçue pour former des électrodes 101 les plus efficaces possibles. Par exemple, si la face intérieure de la première partie réalisée en matériau isolant est plate, les structures métalliques peuvent se présenter sous la forme d"une structure en T. La branche centrale est la branche fixée sur le circuit imprimé alors que la branche perpendiculaire à cette branche centrale est celle qui forme l'électrode en face de laquelle le doigt se placera. Dans un autre exemple, si la face intérieure de la première partie est courbe, on peut alors imaginer que la structure métallique comprenne une première branche plate parallèle au plan du circuit imprimé. A l'extrémité libre de cette première branche parallèle, une seconde branche plate s'étend. Cette seconde branche s'étend perpendiculairement à la première branche. Cette branche peut s'étendre de sorte à former une structure en T ou simplement s'étendre pour former une structure similaire aux brides de fixation précédemment décris. A une extrémité de cette seconde branche, une troisième branche courbe s'étend. Cette troisième branche courbe s'étend de sorte à former une surface convexe. Dans le cas d'une première branche et d'une seconde branche formant une structure en T, la troisième partie courbe s'étend entre les deux extrémités. On peut alors adapter la forme des électrodes à la forme de la carrure et plus précisément à la forme de la première partie.

Dans une troisième solution, qui ne fait pas partie de l'invention, les électrodes 101 sont des circuits flexibles 107. En effet, les circuits flexibles 107 sont constitués d'un substrat réalisé en un matériau souple sur lequel des pistes électriques sont réalisées. Ces circuits imprimés flexibles 107 présentent alors l'avantage de pouvoir s'adapter aux formes complexes des boîtiers dans lesquels ils sont agencés. Les circuits flexibles sont fixés par une extrémité au circuit imprimé, l'autre l'extrémité étant laissé libre. Cette extrémité libre peut donc être fléchie pour que ledit circuit imprimé flexible puisse épouser la forme de la face intérieure de la première partie. De préférence, les pistes conductrices du circuit imprimé flexible sont en contact avec la face intérieure de la première partie.

Dans une autre variante, qui ne fait pas partie de l'invention, chaque électrode du système d'électrode 100 se présente sous la forme d'une pastille en matériaux électriquement conducteurs. Cette pastille en matériaux électriquement conducteur est située sur la face intérieure de la première partie de la carrure. Cette pastille peut être constituée d'une couche de matériau électriquement conducteur ou une couche de peinture conductrice déposée sur la face intérieure de la première partie de la carrure ou une feuille de matériau électriquement conducteur fixée ou collé sur la face intérieure de la première partie de la carrure. Le système d'électrode comprend également des moyens de liaison permettant de relier électriquement chaque pastille formant électrode 101 au circuit imprimé 10c du mouvement horloger. Ces moyens de liaison peuvent, suivant la configuration de la pièce d'horlogerie, se présenter sous différentes formes. Par exemple, ces moyens de liaison peuvent être un fil électrique ou un circuit imprimé flexible ou de la colle conductrice ou même une bride métallique.

L'avantage d'une telle variante est d'avoir un positionnement des électrodes par rapport à la première partie de la carrure qui est parfait. En effet, en réalisant directement les électrodes 101 sur la face intérieure de la première partie de la carrure, on est certain que lesdites électrodes seront bien positionnées. Dès lors, même si le mouvement horloger devait avoir une position décalée par rapport à sa position optimale, les électrodes ne seraient pas décalées. Les moyens de liaison tels que les fils électriques ou les circuits imprimés flexibles sont alors agencés pour compenser ce décalage.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

On comprendra que les moyens tactiles 21 agencés selon la présente invention sont utilisés pour la manipulation des différentes fonctions de la pièce d'horlogerie comme par exemple réaliser le réglage de l'heure courante, d'une date ou le réglage de l'heure d'une alarme. Pour cela, il peut être prévu que les moyens tactiles, agencés au niveau de la zone 3h et/ 9h de la carrure soient dotés d'au moins deux électrodes soit au moins deux touches tactiles. Dans un cas particulier, la carrure est dotée de trois électrodes soit trois touches tactiles. Dans ce cas particulier, pour l'exemple du réglage de l'heure courante, il peut être envisagé qu'une première électrode soit utilisée pour activer la fonction alors que les seconde et troisième électrodes sont utilisées pour incrémenter ou décrémenter l'heure courante. La première électrode est également utilisée pour confirmer le réglage de l'heure courante.

Par ailleurs, on comprendra que pour un objet portable 1 autre qu'une pièce d'horlogerie, ledit objet portable électronique ne comprendra qu'un boîtier 3 muni d'au moins une première partie 3a en matériaux isolants. L'objet électronique portable comprend au moins un module électronique 10 fournissant au moins une information aux moyens d'affichage 15 pouvant être, par exemple, un écran LCD intégré au boitier.

## Revendications

1. Objet électronique portable (1) comprenant un boîtier (3) constitué d'une carrure (5) munie de flancs (50), le boîtier (3) comprenant au moins une première partie (3a) en matériaux isolants, ledit objet électronique portable comprenant au moins un module électronique (10) fournissant au moins une information à des moyens d'affichage (15), ledit objet électronique portable comprenant en outre des moyens de commande (20) permettant à l'utilisateur d'agir sur ledit au moins un module électronique, lesdits moyens de commande comprenant au moins des moyens de commande tactiles (21) agencés sur un desdits flanc (50), les moyens de commande tactiles (21) comprenant au moins un système d'électrode (100) disposés au niveau de ladite au moins une première partie, ledit au moins un système d'électrode (100) comprenant un support (103) en matériaux isolants sur lequel au moins une électrode (101) est agencée, ledit système d'électrode comprenant en outre des moyens de fixation (104) pour fixer ledit support au module électronique (10) et connecter électriquement ladite au moins une électrode au module électronique, **caractérisé en ce que** les moyens de fixation (104) comprennent au moins une bride de fixation (105) en matériaux conducteurs fixés d'une part au module électronique et d'autre part au support permettant une conduction électrique entre ledit module électronique et ladite au moins une électrode.

2. Objet électronique portable selon la revendication 1, **caractérisé en ce que** ladite au moins une électrode (101) est une feuille réalisée en matériaux électriquement conducteurs fixée sur ledit support (103).

3. Objet électronique portable selon la revendication 1, **caractérisé en ce que** ladite au moins une électrode (101) est directement réalisée sur ledit support (103).

4. Objet électronique portable selon l'une des revendications 1 à 3, caractérisé que ledit au moins un système d'électrode (100) comprend une pluralité d'électrode (101) agencée sur le même support (103).

5. Objet électronique portable selon l'une des revendications précédentes, **caractérisé en ce que** le boîtier (3) est réalisée entièrement en matériaux isolants.

6. Objet électronique portable selon l'une des revendications précédentes, **caractérisé en ce que** le matériau isolant est une céramique.

7. Objet électronique portable selon l'une des revendications 1 à 6, **caractérisé en ce que** ledit système d'électrode (100) est situé à proximité de la face intérieure (3b, 5a) de ladite première partie (3a, 5).

8. Objet électronique portable selon l'une des revendications 1 à 6, **caractérisé en ce que** ledit système d'électrode (100) est en contact avec la face intérieure (3b, 5a) de ladite première partie (3a, 5).

9. Objet électronique portable selon l'une des revendications précédentes, **caractérisé en ce que** le boitier (3) est formé d'une carrure (5) fermée par une glace (7) et un fond (9).

10. Objet électronique portable selon l'une des revendications précédentes, **caractérisé en ce que** ledit objet portable est une pièce d'horlogerie.

## Patentansprüche

1. Tragbarer elektronischer Gegenstand (1), umfassend ein Gehäuse (3), bestehend aus einer mit Flanken (50) versehenen Mitte (5), das Gehäuse (3) umfassend mindestens einen ersten Teil (3a) hergestellt aus Isoliermaterialien, das tragbare elektronische Objekt umfassend mindestens ein elektronisches Modul (10), das mindestens ein Stück von Informationen an Anzeigemittel (15) bereitstellt, das tragbare elektronische Objekt ferner umfassend Steuermittel (20), die dem Benutzer ermöglichen, auf das mindestens eine elektronische Modul einzuwirken, die Steuerungsmittel umfassend mindestens taktile Steuermittel (21), die an einer der Flanken (50) angeordnet sind, die taktilen Steuerungsmittel (21) umfassend mindestens ein Elektrodensystem (100), das in dem mindestens einen ersten Teil angeordnet ist, das mindestens eine Elektrodensystem (100) umfassend eine Stütze (103) aus Isoliermaterialien, auf der mindestens eine Elektrode (101) angeordnet ist, das Elektrodensystem ferner umfassend Befestigungsmittel (104) für ein Befestigen der Stütze an dem elektronischen Modul (10) und ein elektrisches Verbinden der mindestens einen Elektrode mit dem elektronischen Modul, **dadurch gekennzeichnet, dass** die Befestigungsmittel (104) mindestens eine Befestigungsklemme (105) aus leitfähigem Material umfassen, die einerseits an dem elektronischen Modul und andererseits an der Stütze befestigt ist und eine elektrische Leitfähigkeit zwischen dem elektronischen Modul und der mindestens einen Elektrode ermöglicht.

2. Tragbarer elektronischer Gegenstand nach Anspruch 1, **dadurch gekennzeichnet, dass** die mindestens eine Elektrode (101) ein Blech aus elektrisch leitfähigem Material ist, das an der Stütze (103) befestigt ist.

3. Tragbarer elektronischer Gegenstand nach Anspruch 1, **dadurch gekennzeichnet, dass** die mindestens eine Elektrode (101) direkt auf der Stütze (103) hergestellt ist.

4. Tragbares elektronisches Objekt nach einem der Ansprüche 1 bis 3, **dadurch gekennzeichnet, dass** das mindestens eine Elektrodensystem (100) eine Mehrzahl von Elektroden (101) umfasst, die auf derselben Stütze (103) angeordnet sind.

5. Tragbarer elektronischer Gegenstand nach einem der vorhergehenden Ansprüche, **dadurch gekennzeichnet, dass** das Gehäuse (3) vollständig aus Isoliermaterialien hergestellt ist.

6. Tragbarer elektronischer Gegenstand nach einem der vorhergehenden Ansprüche, **dadurch gekennzeichnet, dass** das Isoliermaterial eine Keramik ist.

7. Tragbarer elektronischer Gegenstand nach einem der Ansprüche 1 bis 6, **dadurch gekennzeichnet, dass** das Elektrodensystem (100) in der Nähe der Innenfläche (3b, 5a) des ersten Teils (3a, 5) angeordnet ist.

8. Tragbarer elektronischer Gegenstand nach einem der Ansprüche 1 bis 6, **dadurch gekennzeichnet, dass** das Elektrodensystem (100) in Kontakt mit der Innenfläche (3b, 5a) des ersten Teils (3a, 5) steht.

9. Tragbarer elektronischer Gegenstand nach einem der vorhergehenden Ansprüche, **dadurch gekennzeichnet, dass** das Gehäuse (3) aus einer Mitte (5), die durch ein Glas (7) verschlossen ist, und einer Rückseite (9) gebildet ist.

10. Tragbarer elektronischer Gegenstand nach einem der vorhergehenden Ansprüche, **dadurch gekennzeichnet, dass** der tragbare Gegenstand ein Zeitmesser ist.

## Claims

1. A portable electronic object (1) comprising a case (3) consisting of a middle (5) provided with sides (50), the case (3) comprising at least a first part (3a) made of insulating materials, said portable electronic object comprising at least one electronic module (10) providing at least one piece of information to display means (15), said portable electronic object further comprising control means (20) enabling the user to act on said at least one electronic module, said control means comprising at least tactile control means (21) arranged on one of said sides (50), the tactile control means (21) comprising at least one electrode system (100) arranged in said at least one first part, said at least one electrode system (100) comprising a support (103) made of insulating materials on which at least one electrode (101) is arranged, said electrode system further comprising securing means (104) for attaching said support to the electronic module (10) and electrically connecting said at least one electrode to the electronic module, **characterised in that** the securing means (104) comprise at least one attachment clamp (105) made of conductive materials attached, on one hand, to the electronic module and on the other hand to the support enabling electrical conduction between said electronic module and said at least one electrode.

2. The portable electronic object according to claim 1, **characterised in that** said at least one electrode (101) is a sheet made of electrically conductive materials attached to said support (103).

3. The portable electronic object according to claim 1, **characterised in that** said at least one electrode (101) is made directly on said support (103).

4. The portable electronic object according to any of claims 1 to 3, **characterised in that** said at least one electrode system (100) comprises a plurality of electrodes (101) arranged on the same support (103).

5. The portable electronic object according to any of the preceding claims, **characterised in that** the case (3) is made entirely of insulating materials.

6. The portable electronic object according to any of the preceding claims, **characterised in that** the insulating material is a ceramic.

7. The portable electronic object according to any of claims 1 to 6, **characterised in that** said electrode system (100) is located in proximity to the inner face (3b, 5a) of said first part (3a, 5).

8. The portable electronic object according to any of claims 1 to 6, **characterised in that** said electrode system (100) is in contact with the inner face (3b, 5a) of said first part (3a, 5).

9. The portable electronic object according to any of the preceding claims, **characterised in that** the case (3) is formed of a middle (5) closed by a glass (7) and a back (9).

10. The portable electronic object according to any of the preceding claims, **characterised in that** said portable object is a timepiece.
